# EUROPEAN PATENT SPECIFICATION

(11) **EP 1 238 446 B1**
(45) Date of publication and mention of the grant of the patent: **12.11.2003**
(21) Application number: 00983079.5
(22) Date of filing: 14.12.2000
(51) Int. Cl.: H01R 13/24

(54) **AN ELECTRICAL CONTACT DEVICE FOR INTERCONNECTING ELECTRICAL COMPONENTS**
ELEKTRISCHE KONTAKTIERUNGSEINRICHTUNG ZUM VERBINDEN ELEKTRISCHER BAUELEMENTE
DISPOSITIF DE CONTACT ELECTRIQUE PERMETTANT DE RELIER DES COMPOSANTS ELECTRIQUES

(30) Priority: 14.12.1999 DK 178499
(43) Date of publication of application: 11.09.2002
(73) Proprietor: SONIONKIRK A/S, 8700 Horsens (DK)
(72) Inventor: HANSEN, Kaj, Borge, DK-8700 Horsens (DK)
(74) Representative: Sigh, Erik
(86) International application number: DK0000694
(87) International publication number: WO01045213

(56) References cited:
- EP-A- 0 755 165
- DE-A- 3 716 205
- US-A- 3 862 751
- US-A- 4 458 293
- US-A- 4 678 880
- US-A- 5 014 004

## Description

The invention relates to an electrical contact device comprising at least two helically wound electrically conductive, resilient wires, for electrically interconnecting electrical or electronic components or devices.

A contact device of the invention can be used in electrical and electronic components for forming resilient terminals that are suitable for contacting corresponding contact surfaces on a printed circuit board.

A contact device of the invention can also be used on a printed circuit board for forming, on the printed circuit board, resilient terminals that are suitable for contacting corresponding contact surfaces on an electrical or electronic component.

WO 98/43317 shows a contact device in the form of a helically wound electrically conductive, resilient wire, for electrically interconnecting two electrical or electronic components or devices.

EP 755 165 shows an electro acoustic transducer for mounting in a telephone handset. The transducer has two helical spring contact members arranged outside the periphery of the diaphragm. The transducer must be properly oriented prior to being mounted in a telephone.

EP 490 214 shows an electro acoustic transducer with spring contact members in the form of closed resilient loops.

DE 9 407 781.1 U1 shows an electro acoustic transducer with two simple leaf spring contact members.

WO 98/38832 shows an electro acoustic transducer with U-shaped spring contact members.

WO 92/20120 discloses an electrical contact device according to the preamble of claim 1, which is a screened contact especially for screened coaxial cables. The contact has two coaxially arranged helical springs terminating in contact members.

Spring contact members fall in two categories: leaf springs and helical springs. Leaf spring contact members generally have the disadvantage of being resilient substantially only in one direction, ie in the axial direction of the transducer. When the telephone handset or mobile telephone with such transducer is subjected to chock eg by accidentally falling onto a floor, the spring contact members may rub on the contact surface, whereby eg a gold plating can eventually be rubbed off and leave the electrically conductive metal underneath open to attack by the atmosphere which can lead to corrosion. Corroded contacts give bad electrical connections and can become a source of electrical noise.

The component of the invention has at least two helically wound electrical terminals arranged one within the other, preferably co-axially. Hereby a very compact electrical or electronic component or transducer with reliable and stable electrical termination is achieved.

In the following a preferred embodiment of the invention will be described with reference to the accompanying drawings, in which
Figure 1 is a perspective view of a contact device in a preferred embodiment of the invention,
Figure 2 is a longitudinal section through the contact device in figure 1 taken along the line VI-VI, and
Figure 3 shows in perspective how the contact device in figure 2 can be mounted in an opening in a printed circuit board.

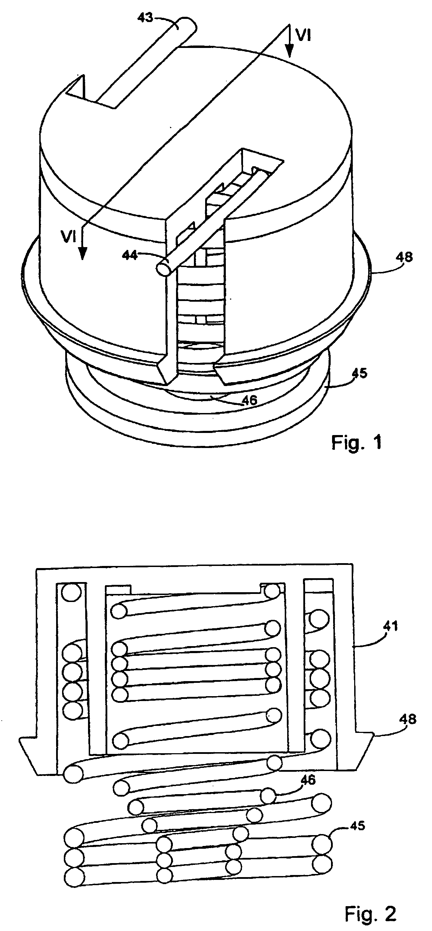

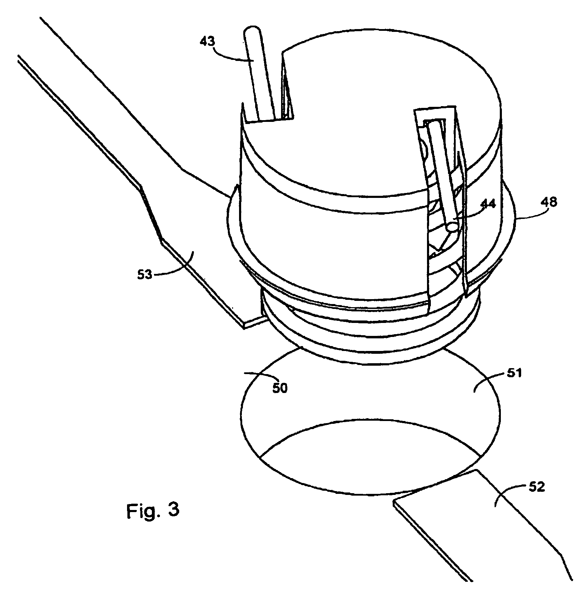

Figures 1-3 show a contact device 40 which has two concentrically mounted helically wound spring contact members 45, 46 in a frame 41 preferably of a resilient material such as a moulded plastics material providing electrical insulation between the spring contact members. The frame is cup shaped with a closed bottom, and the cylindrical walls of the frame have two longitudinal slits 47 dividing the walls into two half-cylindrical shells resiliently interconnected by the bottom wall of the frame. The inner ends 43, 44 of each of the two spring contact members 45, 46 protrude through the slits 47.

Figure 3 shows a printed circuit board 50 with an aperture 51 and two electrically conductive portions 52, 53. The contact device 40 can be mounted in the aperture 51 eg in a snap action whereby the free ends of the two spring contact members will protrude beyond the opposite side of the printed circuit board 50, and the inner ends 43, 44 will touch the electrically conductive portions 52, 53 on the printed circuit board 50. Electrically stable contact will be established eg by reflow soldering, and the frame is made of a material such as LCP which can resist the temperatures employed for the reflow soldering process.

The electrically conductive portions 52, 53 can extend as shown over relative small angles around the aperture 51, or they can extend over larger angles - possibly up to 180 degrees or slightly less, whereby the contact device needs not be angularly oriented with high precision before mounting.

Alternatively, the inner ends 43, 44 of the spring contact members can end on the periphery of the frame and possibly have a bent end. Correspondingly, the electrically conductive portions 52, 53 can extend into the aperture 51 and cover portions of the inner surface of the aperture. When mounted in the aperture the inner ends 43, 44 of the spring contact members will touch the electrically conductive portions radially.

With the contact device of the invention received in the aperture of the printed circuit board, the resilient portions of the spring contact members will largely be accommodated within the printed circuit board resulting in a very flat and compact structure, possibly with no portions or only insignificant portions protruding from the surfaces of the printed circuit board.

Both spring contact members 45, 46 are of helically wound electrically conductive, resilient wire. The two spring contact members 45, 46 are preferably of the type disclosed in WO 98/43317. Both spring contact members are resilient in their axial direction and also in any direction transverse to the axial direction. The inner spring contact member 46 has a conical portion whereby its free end is relatively narrow, and both spring contact members 45, 46 will thereby have a relatively large free lateral play without touching each other. Making the outer spring contact member 25 flaring towards its free end can further increase the free play. The outer cylindrical shell of the frame 41 has two diametrically opposite slots dividing the shell into two halves, which at their free ends have an outwardly protruding lip 48.

In figure 3 the contact device is about to be mounted in the aperture 51. The contact device is inserted by pressing it through the aperture, whereby the lips 48 and the two outer half shells will flex inwardly and will pass through the aperture. With a snap fit the lips 48 will hold the contact device in position in the aperture.

## Claims

1. An electrical contact device for electrically interconnecting two electrical or electronic components or devices, the contact device comprising two resilient, helically wound, electrically conductive wires (45, 46) electrically insulated from each other and arranged one within the other, each wire having a free first end,
**characterized in that** each wire has a free second end (43, 44) opposite the respective first end.

2. An electrical contact device according to claim 1, **characterized in that** the two helically wound electrical wires (45, 46) are arranged co-axially.

3. An electrical contact device according to any one of claims 1-2, **characterized in that** the inner one of the electrical wires (46) is tapering towards the first free end thereof.

4. An electrical contact device according to any one of claims 1-3, **characterized in that** the outer one of the electrical wires (45) is flaring towards the first free end thereof.

5. An electrical contact device according to any one of claims 1-4, **characterized in that** it includes a frame (41) holding the two electrical wires (45, 46) in predetermined positions relative to each other.

6. An electrical contact device according to claim 5, **characterized in that** the free second ends are exposed at an outer surface of the frame (41).

7. An electrical contact device according to claim 6, **characterized in that** the exposed free second ends of the electrical wires (45, 46) protrude in a direction transverse to the axial direction of the device.

8. An electrical contact device with electrical terminals for electrically connecting an electrical or electronic component or device to other electrical or electronic components or devices, **characterized in that** it includes a contact device according to claim 1-7 with the free first ends of the wires (45, 46) forming the terminals of the device.

9. An electrical contact device according to claim 8, **characterized in that** the electrical or electronic component or device is a printed circuit board (50) and the free first ends of the wires (45, 46) are suitable for contacting corresponding contact surfaces on an electrical or electronic component.

10. An electrical contact device according to claim 9, **characterized in that** the printed circuit board (50) has an aperture (51) with the contact device received in the aperture (51) and the free second ends (43, 44) in contact with electrically conductive portions (52, 53) on the printed circuit board.

## Patentansprüche

1. Elektrische Kontaktierungseinrichtung zur Herstellung einer elektrischen Verbindung zwischen zwei elektrischen oder elektronischen Bauelementen, bestehend aus zwei elastischen spiralförmig gewickelten elektrisch leitenden Drähten (45, 46), die gegeneinander isoliert und ineinander eingesetzt sind, wobei jeder Draht ein freies erstes Ende aufweist,
**dadurch gekennzeichnet, dass** jeder Draht gegenüber dem entsprechenden ersten Ende ein freies zweites Ende (43, 44) hat.

2. Elektrische Kontaktierungseinrichtung nach Anspruch 1,
**dadurch gekennzeichnet, dass** die zwei spiralförmig gewickelten elektrischen Drähte (45, 46) koaxial angeordnet sind.

3. Elektrische Kontaktierungseinrichtung nach Anspruch 1 oder 2,
**dadurch gekennzeichnet, dass** sich der innere Draht der elektrischen Drähte (46) zu seinem ersten freien Ende hin verjüngt.

4. Elektrische Kontaktierungseinrichtung nach einem der Ansprüche 1 bis 3,
**dadurch gekennzeichnet, dass** sich der äußere Draht der elektrischen Drähte (45) zu seinem ersten freien Ende hin aufweitet.

5. Elektrische Kontaktierungseinrichtung nach einem der Ansprüche 1 bis 4,
**dadurch gekennzeichnet, dass** zu ihr ein Gehäuse (41) gehört, das die zwei elektrischen Drähte (45, 46) in bestimmten Positionen zueinander hält.

6. Elektrische Kontaktierungseinrichtung nach Anspruch 5,
**dadurch gekennzeichnet, dass** die freien zweiten Enden an einer Außenfläche des Gehäuses (41) freiliegen.

7. Elektrische Kontaktierungseinrichtung nach Anspruch 6,
**dadurch gekennzeichnet, dass** die freiliegenden freien zweiten Enden der elektrischen Drähte (45, 46) im rechten Winkel zur axialen Richtung der Einrichtung hervorstehen.

8. Elektrische Kontaktierungseinrichtung mit elektrischen Anschlüssen zur Herstellung einer elektrischen Verbindung zwischen einem elektrischen oder elektronischen Bauelement und anderen elektrischen oder elektronischen Bauelementen,
**dadurch gekennzeichnet, dass** sie aus einer Kontaktierungseinrichtung nach den Ansprüchen 1 bis 7 mit freien ersten Enden der Drähte (45, 46) besteht, die als Anschlüsse der Einrichtung dienen.

9. Elektrische Kontaktierungseinrichtung nach Anspruch 8,
**dadurch gekennzeichnet, dass** das elektrische oder elektronische Bauelement eine Leiterplatte (50) ist und die freien ersten Enden der Drähte (45, 46) zur Kontaktherstellung entsprechender Kontaktflächen an dem elektrischen oder elektronischen Bauelement geeignet sind.

10. Elektrische Kontaktierungseinrichtung nach Anspruch 9,
**dadurch gekennzeichnet, dass** die Leiterplatte (50) eine Öffnung (51) hat, wobei die Kontaktierungseinrichtung in diese Öffnung (51) eingesetzt ist und die freien zweiten Enden (43, 44) mit den elektrisch leitenden Abschnitten (52, 53) an der Leiterplatte in Kontakt stehen.

## Revendications

1. Dispositif de contact électrique pour interconnecter électriquement deux composants ou dispositifs électriques ou électroniques, le dispositif de contact comprenant deux fils électriquement conducteurs, élastiques, hélicoïdaux (45, 46), isolés électriquement l'un de l'autre et agencés l'un dans l'autre, chaque fil comportant une première extrémité libre,
**caractérisé en ce que** chaque fil comporte une deuxième extrémité libre (43, 44) opposée à la première extrémité respective.

2. Dispositif de contact électrique selon la revendication 1, **caractérisé en ce que** les deux fils électriques hélicoïdaux (45, 46) sont agencés de manière coaxiale.

3. Dispositif de contact électrique selon l'une quelconque des revendications 1 à 2, **caractérisé en ce que** la forme du fil intérieur (46) parmi les fils électriques se réduit vers sa première extrémité libre.

4. Dispositif de contact électrique selon l'une quelconque des revendications 1 à 3, **caractérisé en ce que** la forme du fil extérieur (45) parmi les fils électriques s'évase vers sa première extrémité libre.

5. Dispositif de contact électrique selon l'une quelconque des revendications 1 à 4, **caractérisé en ce qu'**il comprend une structure (41) maintenant les deux fils électriques (45, 46) dans des positions prédéterminées l'un par rapport à l'autre.

6. Dispositif de contact électrique selon la revendication 5, **caractérisé en ce que** les deuxièmes extrémités libres sont exposées au niveau d'une surface extérieure de la structure (41).

7. Dispositif de contact électrique selon la revendication 6, **caractérisé en ce que** les deuxièmes extrémités libres exposées des fils électriques (45, 46) font saillie dans une direction transversale à la direction axiale du dispositif.

8. Dispositif de contact électrique comportant des bornes électriques pour connecter électriquement un composant ou un dispositif électrique ou électronique à d'autres composants ou dispositifs électriques ou électroniques, **caractérisé en ce qu'**il comprend un dispositif de contact selon les revendications 1 à 7, les premières extrémités libres des fils (45, 46) formant les bornes du dispositif.

9. Dispositif de contact électrique selon la revendication 8, **caractérisé en ce que** le composant ou le dispositif électrique ou électronique est une carte de circuit imprimé (50) et les premières extrémités libres des fils (45, 46) sont adaptées pour venir en contact avec des surfaces de contact correspondantes sur un composant électrique ou électronique.

10. Dispositif de contact électrique selon la revendication 9, **caractérisé en ce que** la carte de circuit imprimé (50) comporte une ouverture (51), le dispositif de contact étant reçu dans l'ouverture (51) et les deuxièmes extrémités libres (43, 44) étant en contact avec des parties électriquement conductrices (52, 53) sur la carte de circuit imprimé.
